# EUROPEAN PATENT APPLICATION

(11) **EP 4 123 602 A1**
(43) Date of publication of application: **25.01.2023**
(21) Application number: 22185944.0
(22) Date of filing: 20.07.2022
(51) Int. Cl.: G06V 40/13, G06F 3/044

(54) **FLEXIBLE SENSING DEVICE AND METHOD OF MAKING THE SAME**

(30) Priority: 23.07.2021 TW 110127155
(71) Applicant: Wang, William, New Taipei City 22041 (TW); Su, Yu-Sung, New Taipei City 22041 (TW)
(72) Inventor: Wang, William, New Taipei City 22041 (TW); Su, Yu-Sung, New Taipei City 22041 (TW)
(74) Representative: Murgitroyd & Company

(57) **Abstract**

A flexible sensing device includes a flexible substrate (1) selected from a bismaleimide-triazine resin substrate, an ajinomoto build-up film substrate, and a polyimide film substrate. Multiple first sensing stripes (2) are formed on the flexible substrate (1) and are spaced apart from each other in a first direction (Dl). A dielectric film (3) is superposed on the first sensing stripes (2). Multiple second sensing stripes (4) are formed on the dielectric film (3) and are spaced apart from each other in a second direction (D2). Each second sensing stripe (4) crosses over the first sensing stripes (2) and is spaced apart from the first sensing stripes (2) by the dielectric film (3). A method of making the same is also disclosed.

## Description

The disclosure relates to a sensing device, and more particularly to a flexible sensing device and a method of making the same.

An existing sensing device for fingerprint recognition includes a silicon substrate, multiple sensing stripes formed on the silicon substrate and crossing one another in a spaced-apart manner, and a dielectric film sandwiched between the sensing stripes.

However, due to limitations of the material characteristics of the silicon substrate, a dedicated facility of a semiconductor fabrication plant has to be provided to form the sensing stripes and the dielectric film, thereby causing fabricating inflexibility. In addition, since the silicon substrate itself is a rigid plate-like substrate, the sensing device can only be in the form of a rigid plate. Therefore, there is still room for improvement in the sensing device.

Therefore, one object of the disclosure is to provide a flexible sensing device that can alleviate at least one of the drawbacks of the prior art.

According to the object, a flexible sensing device includes a flexible substrate, a plurality of first sensing stripes, a dielectric film, and a plurality of second sensing stripes.

The flexible substrate is selected from a bismaleimide-triazine resin substrate, an ajinomoto build-up film substrate, and a polyimide film substrate.

The first sensing stripes are formed on the flexible substrate and are spaced apart from each other in a first direction.

The dielectric film is superposed on the first sensing stripes.

The second sensing stripes are formed on the dielectric film and are spaced apart from each other in a second direction transverse to the first direction. Each of the second sensing stripes crosses over the first sensing stripes and is spaced apart from the first sensing stripes by the dielectric film.

Another object of the disclosure is to provide a method of making the flexible sensing device.

Accordingly, a method of the disclosure includes
forming a plurality of first sensing stripes spaced apart in a first direction on a flexible substrate, the flexible substrate being selected from a bismaleimide-triazine resin substrate, an ajinomoto build-up film substrate, and a polyimide film substrate;
superposing a dielectric film on the first sensing stripes; and
forming a plurality of second sensing stripes spaced apart in a second direction transverse to the first direction on the dielectric film, such that each of the second sensing stripes crosses over the first sensing stripes and is spaced apart from said first sensing wires by the dielectric frim.

Other features and advantages of the disclosure will become apparent in the following detailed description of the embodiments with reference to the accompanying drawings, of which:
Figure 1 is a fragmentary schematic top view illustrating a flexible sensing device according to a first embodiment of the disclosure;
Figure 2 is a fragmentary schematic bottom view of the first embodiment;
Figure 3 is a fragmentary exploded perspective view of the first embodiment;
Figure 4 is a fragmentary sectional view taken along line IV-IV of Figure 1;
Figure 5 is a fragmentary sectional view taken along line V-V of Figure 1;
Figure 6 is a flow chart illustrating a method of making a flexible sensing device of the first embodiment;
Figures 7 and 8 illustrate how to make the flexible sensing device by using the method; and
Figure 9 is a fragmentary top view illustrating a flexible sensing device according to a second embodiment of the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

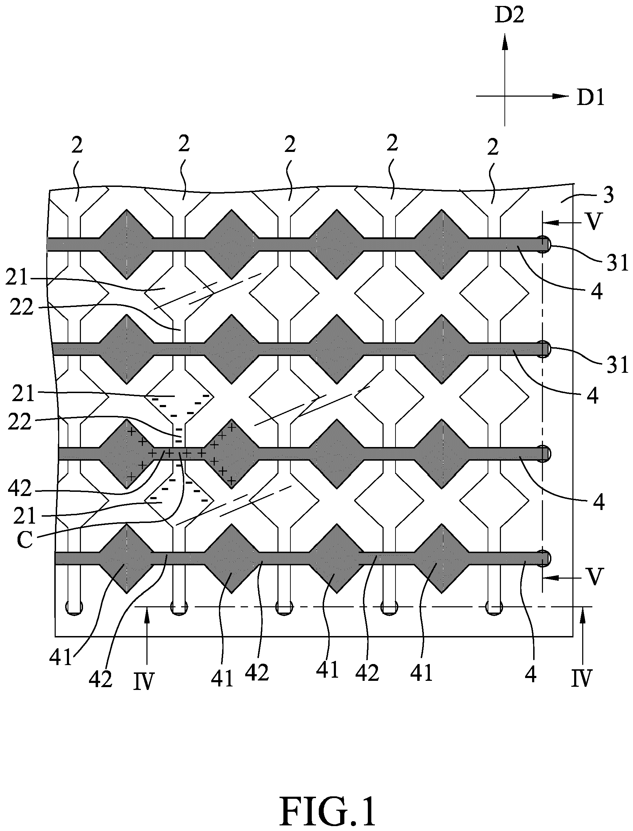

Figure 1 to 3 illustrate a flexible sensing device according to a first embodiment of the disclosure. The flexible sensing device includes a flexible substrate 1, a plurality of first sensing stripes 2, a dielectric film 3, a plurality of second sensing stripes 4, a plurality of first conducting wires 5, a plurality of second conducting wires 6, and a processing chip 7.

The flexible substrate 1 is in a quadrilateral shape and is selected from a bismaleimide-triazine resin substrate, an ajinomoto build-up film substrate, and a polyimide film substrate. The flexible substrate 1 has a first surface 11 and a second surface 12 opposite to the first surface 11. In practice, a thickness of the substrate 1 is greater than 0 mm and smaller than 0.5 mm. As such, when the flexible substrate 1 is flexed, it can have sufficiently predetermined strength to support a film subsequently formed thereon. Specifically, the thickness of the flexible substrate 1 is greater than 0 mm and smaller than 0.1 mm.

The first sensing stripes 2 each in a thin film shape are formed on the first surface 11 of the flexible substrate 1 and are spaced apart from each other in a first direction (D1). The first sensing stripes 2 cover a partial area of the first surface 11, so that the remaining area of the first surface 11 is uncovered by or exposed from the first sensing stripes 2. Each first sensing stripe 2 is made from metal, alloy, or conductive metal oxides. In this embodiment, each first sensing stripe 2 extends in a second direction (D2) perpendicular to the first direction (D1), and has a plurality of rhomboidal first enlarged portions 21 spaced apart from each other in the second direction (D2), and a plurality of first sensing portions 22 each connecting between two adjacent ones of the first enlarged portions 21. A width of each first sensing portion 22 is smaller than that of each first enlarged portion 21.

The dielectric film 3 is superposed on the first sensing stripes 2, and covers the exposed area of the first surface 11 of the flexible substrate 1 uncovered by the first sensing stripes 2. The dielectric film 3 is made from a material selected from a poly(methyl methacrylate) material, a polyimide material, and a hardened photoresist material.

The second sensing stripes 4 each in a thin film shape are formed on a surface of the dielectric film 3 opposite to the first sensing stripes 2 and are spaced apart from each other in the second direction (D2). Each second sensing stripe 4 is made from metal, alloy, or conductive metal oxides. In this embodiment, each second sensing stripe 4 extends in the first direction (D1), and has a plurality of rhomboidal second enlarged portions 41 spaced apart from each other in the first direction (D1), and a plurality of second sensing portions 42 each connecting between two adjacent ones of the second enlarged portions 41. A width of each second sensing portion 42 is smaller than that of each second enlarged portion 41.

Each of the second sensing stripes 4 crosses over the first sensing stripes 2 and is spaced apart from the first sensing stripes 2 by the dielectric film 3. In this embodiment, a junction where each second sensing portion 42 of each second stripe 4 crosses a corresponding one of the first second portions 22 and a region surrounding the junction by two adjacent second enlarged portions 41 and two adjacent first enlarged portions 21 constitute a capacitor (C) in cooperation with the dielectric film 3 for forming an image sensor pixel. In Figure 1, a region depicted by positive and negative charge symbols represents one capacitor (C).

The processing chip 7 is an unpackaged chip before being disposed on the substrate 1, and is packaged when being placed on the second surface 12 of the flexible substrate 1 by using a flip chip technique. The processing chip 7 is used for scanning the image sensor pixels and obtaining a capacitance value from the image sensor pixels. The design of the processing chip 7 being directly packaged to the flexible substrate 1 can reduce the thickness of and simplify manufacturing process of a fingerprint sensing device. In practice, an applied smart card has to pass ISO7816 smart card standards.

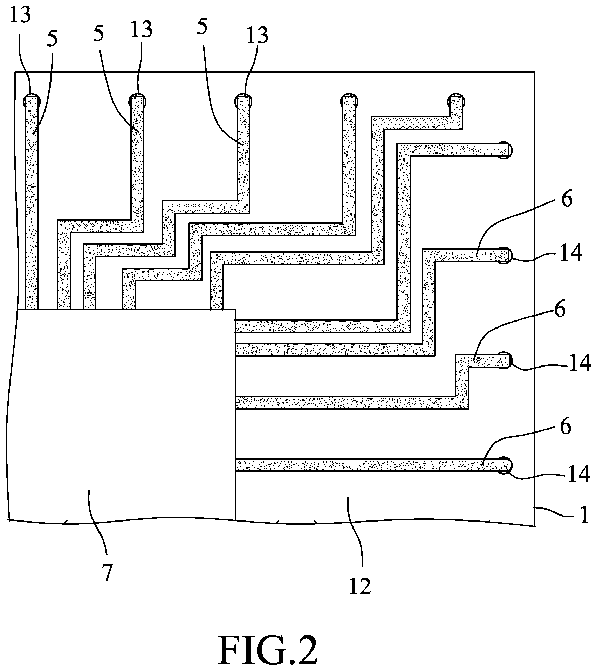

Referring to Figures 2 to 4, the first conducting wires 5, each of which is made of an electric conducting material, extend through the flexible substrate 1 and connect the first sensing stripes 2 and the processing chip 7, so that the processing chip 7 can apply electrical signals and scan the first sensing stripes 2. In this embodiment, the flexible substrate 1 further has a plurality of first through holes 13 that extend through the first and second surfaces 11, 12 and that are spaced apart from each other in the first direction (D1). The first conducting wires 5 respectively pass through the first through holes 13, are formed on the second surface 12 as thin films, and extend to the processing chip 7. By virtue of the first conducting wires 5, the first sensing stripes 2 are signally connected to the processing chip 7.

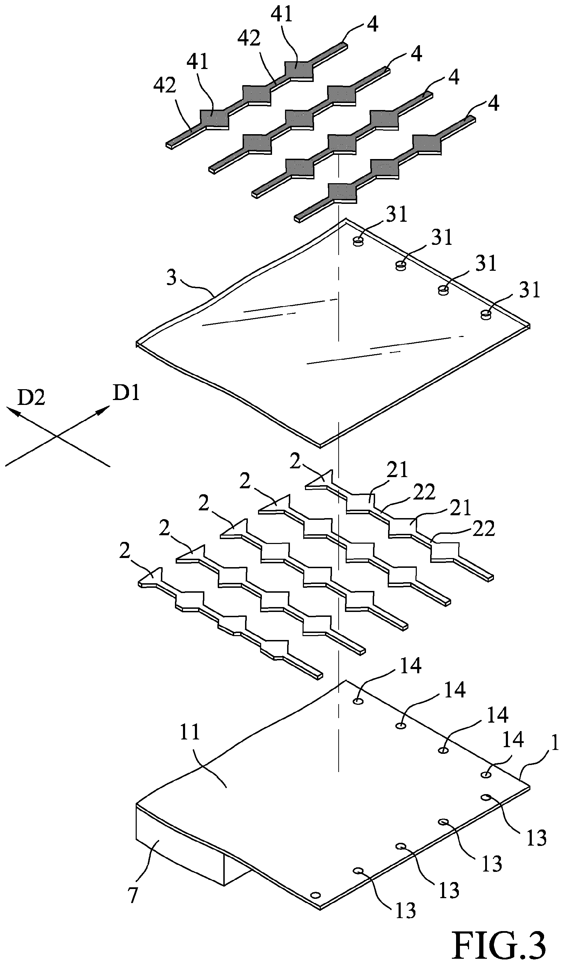

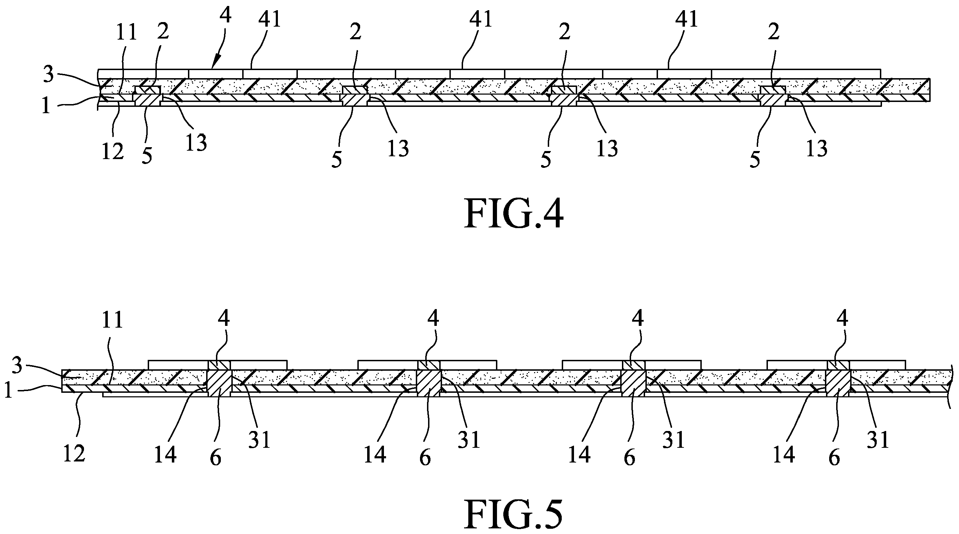

Referring to Figure 5, in combination with Figures 2 and 3, the second conducting wires 6, each of which is made of an electric conducting material, extend through the dielectric film 3 and the flexible substrate 1, and connect the second sensing stripes 4 and the processing chip 7, so that the processing chip 7 can apply electrical signals to and scan the second sensing stripe 4. In this embodiment, the flexible substrate 1 further has a plurality of second through holes 14 that extend through the first and second surfaces 11, 12 and that are spaced apart from each other in the second direction (D2). The dielectric film 3 has a plurality of third through holes 31 that are spaced apart from each other in the second direction (D2) and that are respectively aligned with the second through holes 14. The second conducting wires 6 extend from the second sensing stripes 4, pass through the third and second through holes 31, 14, are formed on the second surface 12 as thin films, and extend to the processing chip 7. By virtue of the second conducting wires 6, the second sensing stripes 4 are signally connected to the processing chip 7.

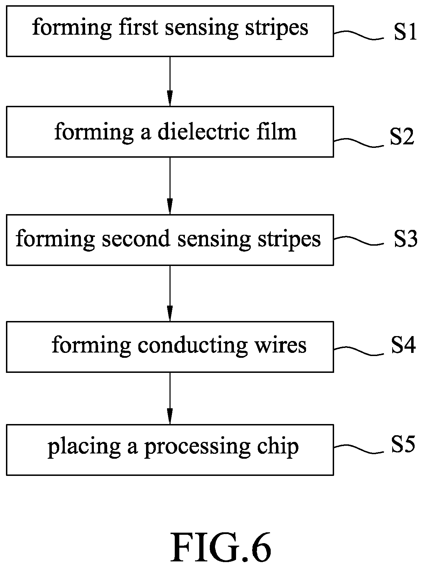

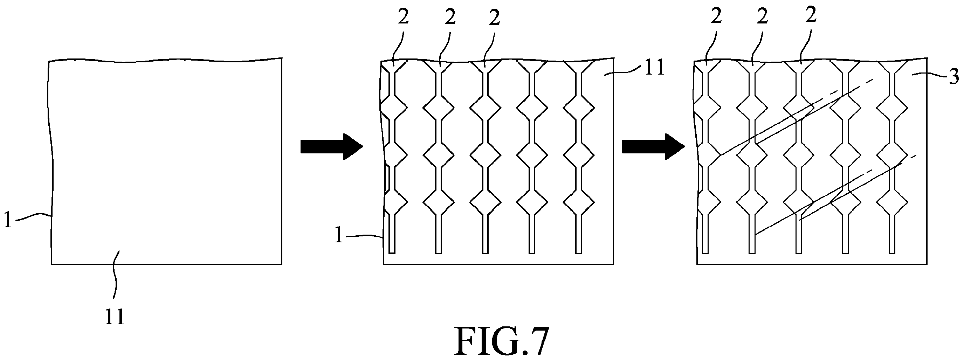

Figures 6 to 8 illustrate a method of making a flexible sensing device of the first embodiment.

First, Step S1 is performed by forming a first metal layer on a first surface 11 of a flexible substrate 1 by using a vapor deposition technique (e.g., a sputtering technique), and removing unnecessary parts of the first metal layer by using lithography and etching techniques, thereby forming a plurality of first sensing stripes 2 and exposing a remaining area of the first surface 11 uncovered by the first sensing stripes 2. In this embodiment, the flexible substrate 1 is selected from a bismaleimide-triazine resin substrate, an ajinomoto build-up film substrate, and a polyimide film substrate. Alternatively, the first sensing stripes 2 can also be directly adhered to the flexible substrate 1.

Step S2 is performed by forming a dielectric material by using a coating technique or a vapor deposition technique on the surfaces of the first sensing stripes 2 opposite to the flexible substrate 1. After the dielectric material is hardened, a dielectric film 3 is superposed on the first sensing stripes 2. To form the dielectric film 3, the dielectric material can be hardened through dry hardening, light hardening, or heat hardening. In this embodiment, the dielectric film 3 is made from a material selected from a poly(methyl methacrylate) material, a polyimide material, and a hardened photoresist material.

Step S3 is performed by forming a second metal layer on the dielectric film 3 by using a vapor deposition technique (e.g., a sputtering technique), and removing unnecessary parts of the second metal layer by using lithography and etching techniques, thereby forming a plurality of second sensing stripes 4 and partially exposing the dielectric film 3. The second sensing stripes 4 are spaced apart in the second direction (D2) on the dielectric film 3, such that each of the second sensing stripes 4 crosses over the first sensing stripes 2 and is spaced apart from the first sensing stripes 2 by the dielectric film 3. Alternatively, the second sensing stripes 4 can also be directly adhered to the dielectric film 3.

As shown in Figures 4, 5, and 8, Step S4 is performed by forming a plurality of first conducting wires 5 that extend through the flexible substrate 1 and that connect the first sensing stripes 2 and the processing chip 7, and forming a plurality of second conducting wires 6 that extend through the flexible substrate 1 and that connect the second sensing stripes 4 and the processing chip 7. In practice, the flexible substrate 1 is drilled therethrough to from a plurality of first through holes 13 and a plurality of second through holes 14. The dielectric film 3 is formed with a plurality of third through holes 31. Each first through hole 13 is aligned with an end portion of a corresponding one of the first sensing stripes 2. Each second through hole 14 is aligned with a corresponding one of the third through holes 31 that is aligned with an end portion of a corresponding one of the second sensing stripes 4 (see Figures 1 and 3). The first, second third through holes 13, 14, 31 are filled with electric conducting materials so as to be parts of the first and second conducting wires 5, 6. The rest parts of the first and second conducting wires 5, 6 are formed on a second surface 12 of the flexible substrate 1, thereby completing connection to the first and second sensing stripes 2, 4. Of course, before the first and second sensing stripes 2, 4 are formed, the first and second through holes 13, 14 can be formed by drilling through the flexible substrate 1. Alternatively, the step S4 of forming the first and second conducting wires 5, 6 can be first performed, and the step S1 of forming the first sensing stripes 2, the step S2 of forming the dielectric film 3, and the step S3 of forming the second sensing stripes 4 can be subsequently performed.

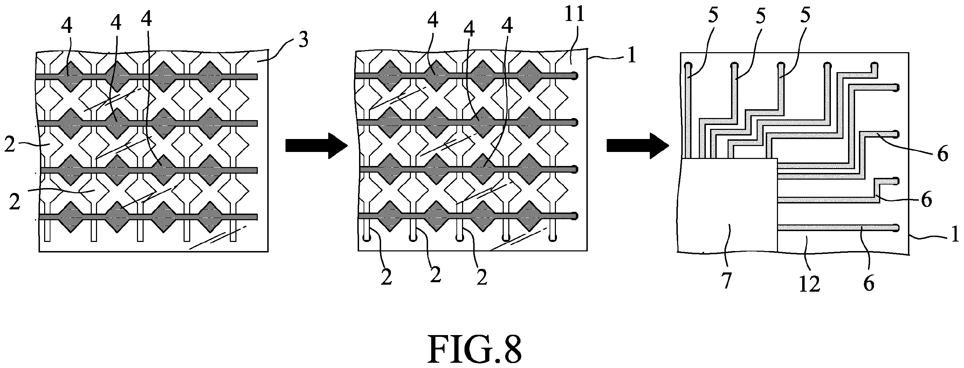

Referring to Figures 6 and 8, Step S5 is performed by placing the processing chip 7 on the surface 12 of the flexible substrate 1 opposite to the first sensing stripes 2 by using a flip chip technique. The processing chip 7 is then adhered on the surface 12 of the flexible substrate 1. As such, making the flexible sensing device of the disclosure is completed.

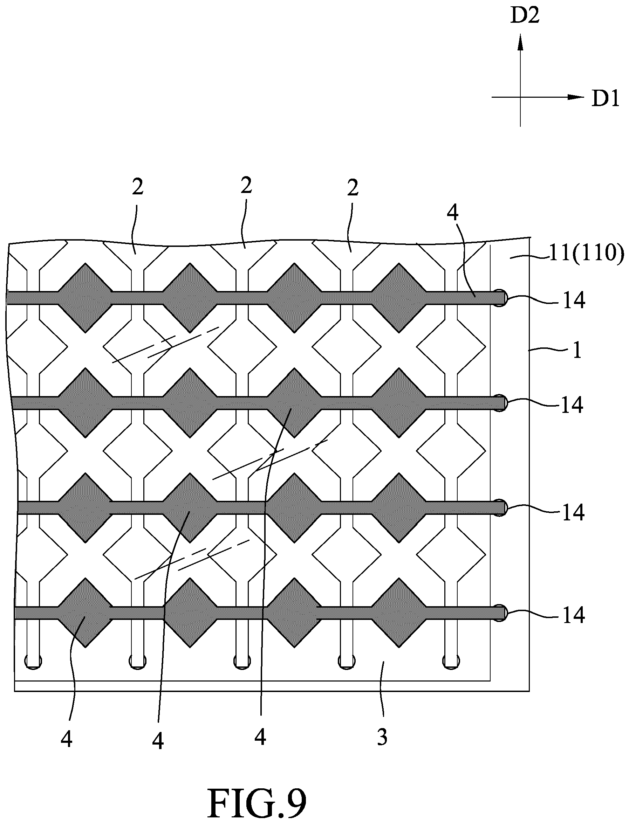

Figure 9 illustrates a flexible sensing device according to a second embodiment of the disclosure, which has a structure generally similar to that of the first embodiment. However, in the second embodiment, the dielectric film 3 uncovers a lateral marginal region 110 of the first surface 11 of the flexible substrate 1. The second through holes 14 extend through the lateral marginal region 110 of the flexible substrate 1 and are thus exposed from the dielectric film 3. Each second sensing stripe 4 extends in the first direction (D1) to the lateral marginal region 110 and meets one of the second through holes 14. By virtue of the second through holes 14 exposed from the dielectric film 3, each second conducting wire 6 from a corresponding one of the second sensing stripes 4 can directly extends through the flexible substrate 1 for connection to the processing chip 7 without passing the dielectric film 3. As such, the dielectric film 3 of this embodiment need not be provided with the third through holes 31 (as shown in Figure 5), thereby eliminating the step of forming the third through holes 31 in the dielectric film 3 during manufacturing.

In summary, by virtue of the flexibility of the flexible substrate 1, the flexible sensing device can be moderately flexed, thereby increasing the flexibility in design and use. Further, the method of making the flexible sensing device of the disclosure is not limited to a specific semiconductor process in which a silicone substrate has to be used.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A flexible sensing device, **characterized by**:
a flexible substrate (1) selected from a bismaleimide-triazine resin substrate, an ajinomoto build-up film substrate, and a polyimide film substrate;
a plurality of first sensing stripes (2) formed on said flexible substrate (1) and spaced apart from each other in a first direction (D1);
a dielectric film (3) superposed on said first sensing stripes (2); and
a plurality of second sensing stripes (4) formed on said dielectric film (3) and spaced apart from each other in a second direction (D2) transverse to the first direction (D1), each of said second sensing stripes (4) crossing over said first sensing stripes (2) and being spaced apart from said first sensing stripes (2) by said dielectric film (3).

2. The flexible sensing device as claimed in Claim 1, **characterized in that** a thickness of said substrate (1) is greater than 0 mm and smaller than 0.5 mm.

3. The flexible sensing device as claimed in Claims 1 or 2, **characterized in that**:
said flexible substrate (1) has a first surface (11) on which said first sensing stripes (2) are formed, and a second surface (12) opposite to said first surface (11); and
said flexible sensing device further includes a processing chip (7) disposed on said second surface (12).

4. The flexible sensing device as claimed in Claim 3, further **characterized by** a plurality of first conducting wires (5) that extend through said flexible substrate (1) and that connect said first sensing stripes (2) and said processing chip (7), and a plurality of second conducting wires (6) that extend through said flexible substrate (1) and that connect said second sensing stripes (4) and said processing chip (7).

5. The flexible sensing device as claimed in any one of Claims 1 to 4, **characterized in that** said dielectric film (3) is made from a material selected from a poly(methyl methacrylate) material, a polyimide material, and a hardened photoresist material.

6. A method of making a flexible sensing device, **characterized by**:
forming a plurality of first sensing stripes (2) spaced apart in a first direction (D1) on a flexible substrate (1), the flexible substrate (1) being selected from a bismaleimide-triazine resin substrate, an ajinomoto build-up film substrate, and a polyimide film substrate;
superposing a dielectric film (3) on the first sensing stripes (2); and
forming a plurality of second sensing stripes (4) spaced apart in a second direction transverse to the first direction (D1) on the dielectric film (3), such that each of the second sensing stripes (4) crosses over the first sensing stripes (2) and is spaced apart from said first sensing wires (2) by the dielectric frim (3).

7. The method as claimed in Claim 6, further **characterized by** placing a processing chip (7) on a surface (12) of the flexible substrate (1) opposite to the first sensing stripes (2) by using a flip chip technique.

8. The method as claimed in Claims 6 or 7, further **characterized by** forming a plurality of first conducting wires (5) that extend through the flexible substrate (1) and that connect the first sensing stripes (2) and the processing chip (7), and forming a plurality of second conducting wires (6) that extend through the flexible substrate (1) and that connect the second sensing stripes (4) and the processing chip (7).

9. The method as claimed in any one of Claims 6 to 8, **characterized in that**:
the forming of the first sensing stripes (2) includes forming the first metal layer on the flexible substrate (1) by using a sputtering technique, and removing unnecessary parts of the first metal layer by using lithography and etching techniques, thereby forming the first sensing stripes (2); and
the forming the second sensing stripes (4) includes forming a second metal layer on the dielectric film (3) by using a sputtering technique, and removing unnecessary parts of the second metal layer by using lithography and etching techniques, thereby forming the second sensing stripes (4).

10. The method as claimed in any one of Claims 6 to 9, **characterized in that** in superposing a dielectric film (3) on the first sensing stripes (2), the dielectric film (3) is formed by a coating technique, and is made from a material selected from a poly(methyl methacrylate) material, a polyimide material, and a hardened photoresist material.
